# EUROPEAN PATENT SPECIFICATION

(11) **EP 2 610 922 B1**
(45) Date of publication and mention of the grant of the patent: **17.06.2015**
(21) Application number: 12187053.9
(22) Date of filing: 02.10.2012
(51) Int. Cl.: H01L 31/052, H01L 27/142

(54) **Photovoltaic module and frame thereof**
Photovoltaikmodul und Rahmen dafür
Module photovoltaïque et son cadre

(30) Priority: 30.12.2011 TW 100149970
(43) Date of publication of application: 03.07.2013
(73) Proprietor: AU Optronics Corporation, Hsin-Chu (TW)
(72) Inventor: Yang, Chun-Ming, Hsin-Chu (TW); Lee, Wei-Jieh, Hsin-Chu (TW)
(74) Representative: Lang, Christian

(56) References cited:
- US-A- 4 137 098
- US-A- 6 147 295
- US-A1- 2002 195 989

## Description

### BACKGROUND

### Technical Field

Embodiments of the present invention relate to a photovoltaic module. More particularly, embodiments of the present invention relate to a photovoltaic module, and to a frame of the photovoltaic module.

### Description of Related Art

In recent years, energy issues have been the focus of much attention. In order to solve the problems associated with using fuel sources to meet energy demands, a variety of alternative energy technologies have been developed. Because solar energy has many advantages, such as being non-polluting and unlimited, it is a popular choice to replace oil energy. Therefore, more and more photovoltaic panels are being disposed on homes, buildings, etc. at locations where there is abundant sunshine.

In a conventional photovoltaic module, a photovoltaic panel is held in a frame fixed on the rooftop of a building. The frame for holding the photovoltaic panel has a poor heat dissipating ability, and therefore, the temperature of the photovoltaic panel may be higher than the ambient temperature by about 30-50 °C. Further, the efficiency of the photovoltaic module may be lowered by about 5% for every 10 °C increase in the temperature of the photovoltaic module. Hence, this poor ability to dissipate heat lowers the efficiency of the photovoltaic module.

US 2002/19589 A1 relates to a charging station for electric cars. The station includes transparent panels and solar panels which are arranged to form a flow tunnel. Within the flow tunnel a wind generator is provided.

It is the object of the present Invention to provide a frame for a photovoltaic panel, which is configured to cool the photovoltaic panel, and a photovoltaic module including such a frame.

### SUMMARY

This object is solved by the frame of a photovoltaic module according to claim 1 and the photovoltaic module according to claim 8. Advantageous improvements of the invention are described by dependent claims.

In accordance with one embodiment of the present invention, a frame of a photovoltaic module is provided. The frame is used for holding a photovoltaic panel, and includes a holding part and an extending part. The holding part is used for holding the photovoltaic panel. The extending part is connected to the holding part and includes at least one first wind tunnel structure, in which the cross-sectional area of an inlet of the first wind tunnel structure is greater than the cross-sectional area of an outlet of the first wind tunnel structure.

In accordance with another embodiment of the present invention, a photovoltaic module is provided. The photovoltaic module includes a photovoltaic panel and a frame. The frame includes a holding part and an extending part. The holding part holds the photovoltaic panel. The extending part is connected to the holding part and includes at least one first wind tunnel structure, in which the cross-sectional area of an inlet of the first wind tunnel structure is greater than the cross-sectional area of an outlet of the first wind tunnel structure.

### BRIEF DESCRIPTION OF THE DRAWINGS

The invention can be more fully understood by reading the following detailed description of the embodiment, with reference made to the accompanying drawings as follows:
Fig. 1 is a cross-sectional view of a frame of a photovoltaic module;
Fig. 2 is a cross-sectional view of an extending part of the frame shown in Fig. 1, in which the direction of cross-section is perpendicular to the direction of cross-section employed in Fig. 1;
Fig. 3 is a cross-sectional view of a frame of a photovoltaic module in accordance with an embodiment of the present invention;
Fig. 4 is a cross-sectional view of an extending part of the frame shown in Fig. 3;
Fig. 5 is a partial side view of the frame of the photovoltaic module shown in Fig. 3;
Fig. 6 is a partial top view of the frame of the photovoltaic module shown in Fig. 3; and
Fig. 7 is a perspective view of the photovoltaic module in accordance with one embodiment shown in Fig. 3 and a partial cross-sectional view of a frame thereof.

### DETAILED DESCRIPTION

Reference will now be made in detail to the present embodiments of the invention, examples of which are illustrated in the accompanying drawings. Wherever possible, the same reference numbers are used in the drawings and the description to refer to the same or like parts.

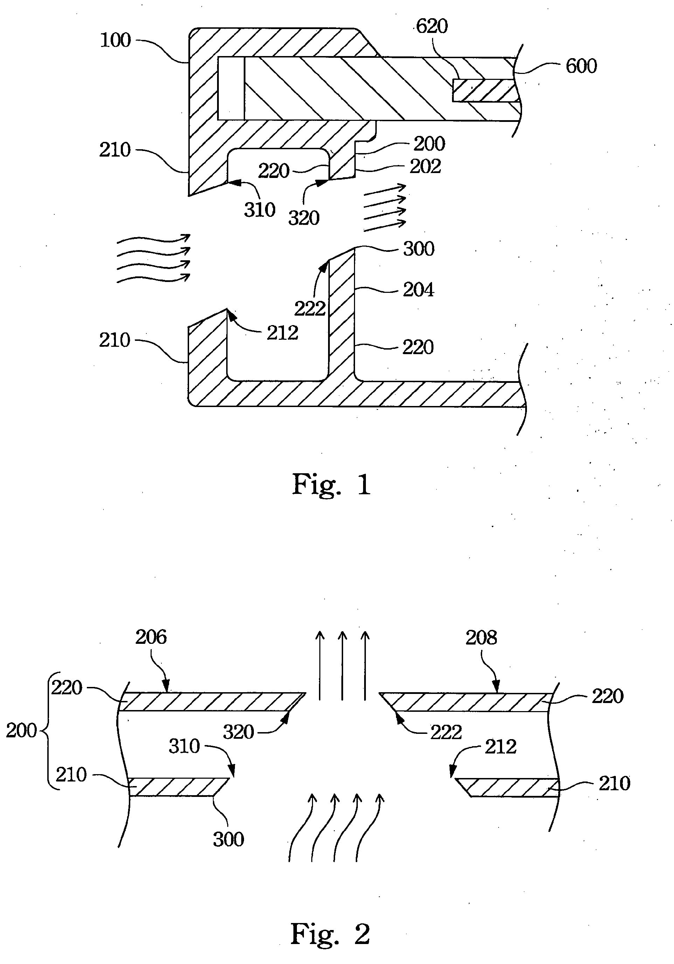

Fig. 1 is a cross-sectional view of a frame of a photovoltaic module which is not in accordance with the present invention but helpful for the understanding thereof. As shown in the figure, the frame may be used for holding a photovoltaic panel 600, and includes a holding part 100 and an extending part 200. The holding part 100 is used for holding the photovoltaic panel 600. The extending part 200 is connected to the holding part 100, and includes at least one first wind tunnel structure 300 having an inlet 310 and an outlet 320. The cross-sectional area of the inlet 310 of the first wind tunnel structure 300 is greater than the cross-sectional area of the outlet 320 of the first wind tunnel structure 300. Further, the extending part 200 can be fastened on a home, building, etc. so as to secure the photovoltaic panel 600 to the home, building, etc.

Through aforementioned configuration, the embodiment employs the first wind tunnel structure 300 to guide the airflow blowing over the undersurface of the photovoltaic panel 600, thereby dissipating heat accumulating under the photovoltaic panel 600. Therefore, the inlet 310 is formed in the outer surface of the frame which is far away from the photovoltaic panel 600, while the outlet 320 is formed in the inner surface of the frame which is closer to the photovoltaic panel 600.

In some embodiments, the extending part 200 of the frame of the photovoltaic module may include an outer wall 210 and an inner wall 220. An intake 212 is formed in the outer wall 210, and a vent 222 is formed in the inner wall 220. For example, the extending part 200 may be a hollow structure with a pair of walls. In this case, one wall that is closer to the photovoltaic panel 600 is the inner wall 220, and the other wall that is far away from the photovoltaic panel 600 is the outer wall 210, and a space is formed between the outer wall 210 and the inner wall 220. The intake 212 can be formed in the outer wall 210, and the vent 222 can be formed in the inner wall 220. The cross-sectional area of the intake 212 is greater than the cross-sectional area of the vent 222, so that the airflow can be accelerated and the heat dissipating ability can be promoted. For example, the intake 212 and the vent 222 may include, but is not limited to including, a circular, elliptical, rectangular, polygonal, or arbitrarily shaped opening. In some embodiments, the extending part 200 may be a solid structure.

In some embodiments, the inlet 310 of the first wind tunnel structure 300 may be the intake 212 formed in the outer wall 210 of the extending part 200, and the outlet 320 of the first wind tunnel structure 300 may be the vent 222 formed in the inner wall 220 of the extending part 200. The cross-sectional area of the intake 212 is greater than the cross-sectional area of the vent 222. With these equivalents in mind, therefore, the cross-sectional area of the inlet 310 of the first wind tunnel structure 300 is greater than the cross-sectional area of the outlet 320.

As shown in the figure, because the cross-sectional area of the Inlet 310 of the first wind tunnel structure 300 is greater than the cross-sectional area of the outlet 320, the airflow velocity at the outlet 320 is greater than the airflow velocity at the inlet 310. The variation of these cross-sectional areas may accelerate the airflow and thereby improves the heat dissipating ability.

In some embodiments, the extending part 200 can be divided by the first wind tunnel structure 300 into an upper extending part 202 and a lower extending part 204. The outer wall 210 of the upper extending part 202 and the outer wall 210 of the lower extending part 204 define the height of the intake 212. Similarly, the inner wall 220 of the upper extending part 202 and the inner wall 220 of the lower extending part 204 define the height of the vent 222. In this embodiment, the height of the intake 212 is greater than the height of the vent 222, so as to make the cross-sectional area of the intake 212 greater than the cross-sectional area 222 of the vent 222, thereby accelerating airflow and improving heat dissipating ability.

Fig. 2 is a cross-sectional view of the extending part 200 of the frame shown in Fig. 1, in which the direction of cross-section is perpendicular to the direction of cross-section of Fig. 1. As shown in this figure, the extending part 200 can be further divided by the first wind tunnel structure 300 into a left extending part 206 and a right extending part 208. The left extending part 206 and the right extending part 208 both have an outer wall 210 and an inner wall 220, in which the outer wall 210 and the inner wall 220 are spatially separated. The outer wall 210 of the left extending part 206 and the outer wall 210 of the right extending part 208 define the width of the intake 212. Similarly, the inner wall 220 of the left extending part 206 and the inner wall 220 of the right extending part 208 define the width of the vent 222. In this embodiment, the width of the intake 212 is greater than the width of the vent 222, so as to make the cross-sectional area of the intake 212 greater than the cross-sectional area of the vent 222 and similarly make the cross-sectional area of the inlet 310 of the first wind tunnel structure 300 greater than the cross-sectional area of the outlet 320, thereby accelerating airflow and improving heat dissipating ability.

It should be noted that the explanation of the differences in height or width of the intake 212 and the vent 222 in the aforementioned embodiments is provided by way of example. A feature of the embodiments described above relates to the fact that the cross-sectional area of the intake 212 is greater than the cross-sectional area of the vent 222. In other embodiments, the cross-sectional area of the intake 212 can be greater than the cross-sectional area of the vent 222 by using other configurations. For example, the intake 212 and the vent 222 may both be circular, and the radius of the intake 212 may be greater than the radius of the vent 222, so as to make the cross-sectional area of the intake 212 greater than the cross-sectional area of the vent 222, thereby accelerating airflow and improving the heat dissipating ability.

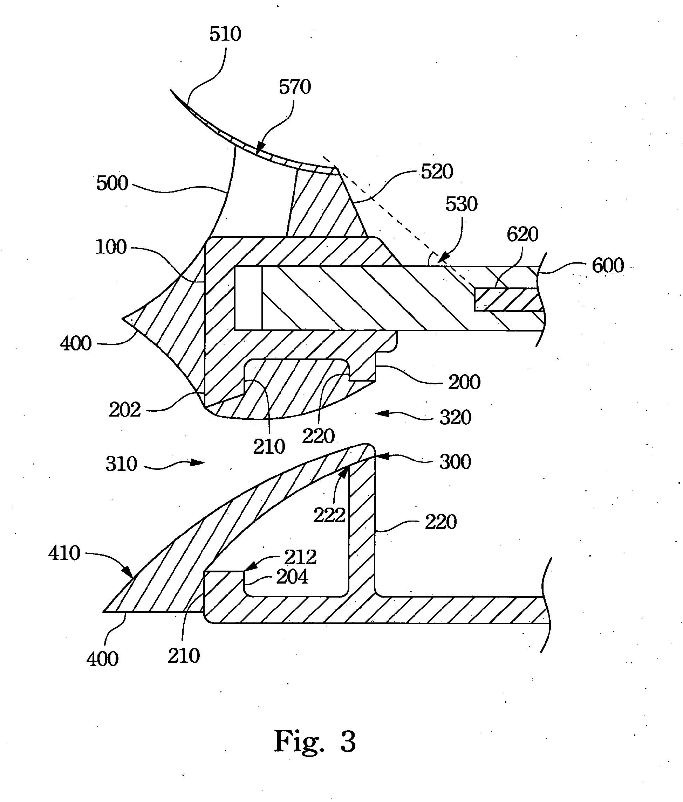

Fig. 3 is a cross-sectional view of a frame of a photovoltaic module in accordance with another embodiment of the present invention. As shown in this figure, the frame may further include at least one flow guiding structure 400 connected to the intake 212 and the vent 222. Specifically, the flow guiding structure 400 crosses over the space formed between the outer wall 210 and the inner wall 220 of the extending part 200 and interconnects the outer wall 210 and the inner wall 220, so as to guide airflow towards the photovoltaic panel 600.

In some embodiments, the flow guiding structure 400 is extended out of the outer wall 210. Specifically, the flow guiding structure 400 can be extended from the inner wall 220 to the outer wall 210 and further extended outside the outer wall 210. In some embodiments, the flow guiding structure 400 can be streamlined, so as to facilitate airflow moving towards the photovoltaic panel 600.

In some embodiments, the flow guiding structure 400 has a windward opening 410, in which the cross-sectional area of the windward opening 410 is greater than the cross-sectional area of the intake 212. For example, the opening of the flow guiding structure 400 expands gradually along the direction away from the outer wall 210. As shown in the figure, the flow guiding structure 400 disposed on the upper extending part 202 extends upwardly along the direction away from the outer wall 210. Contrarily, the flow guiding structure 400 disposed on the lower extending part 204 extends downwardly along the direction away from the outer wall 210.

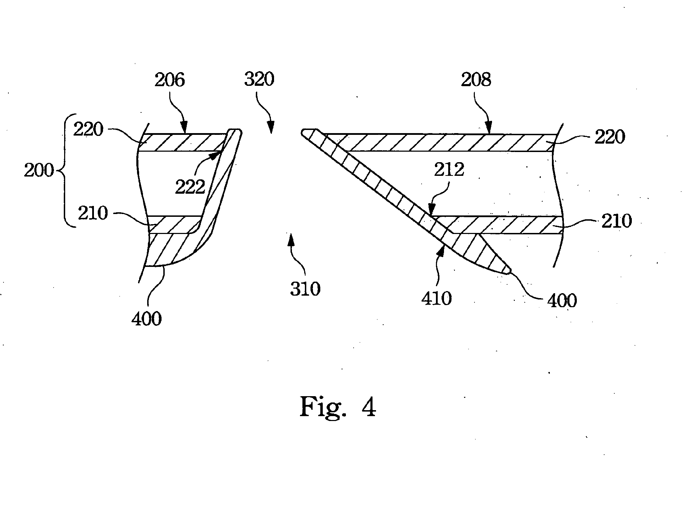

Fig. 4 is a cross-sectional view of the extending part 200 of the frame shown in Fig. 3, in which the direction of cross-section is perpendicular to direction of cross-section employed in Fig. 3. The flow guiding structure 400 disposed on the left extending part 206 extends leftward along the direction away from the outer wall 210. Contrarily, the flow guiding structure 400 extends rightward along the direction away from the outer wall 210. Therefore, the cross-sectional area of the flow guiding structure 400 increases gradually along the direction away from the outer wall 210, so that the cross-sectional area of the windward opening 410 can be greater than the cross-sectional area of the intake 212. Therefore, the velocity of airflow passing through the intake 212 is higher than the velocity of airflow passing through the windward opening 410, so that the flow guiding structure 400 can further accelerate the airflow and thereby improve the heat dissipating ability. In some embodiments, the flow guiding structure 400 can be made of a plastic material. For example, the flow guiding structure 400 can be made of a thermoplastic material, such as TPE (Thermoplastic Elastomer). In some embodiments, the flow guiding structure 400 can be made of metal, such as aluminum, iron, stainless steel, or combinations thereof.

Referring back to Fig. 3, the frame of the photovoltaic module may further include a second wind tunnel structure 500 disposed on the holding part 100. In particular, the second wind tunnel structure 500 is disposed on a side of the holding part 100 that is opposite the side thereof to which the extending part 200 is connected.

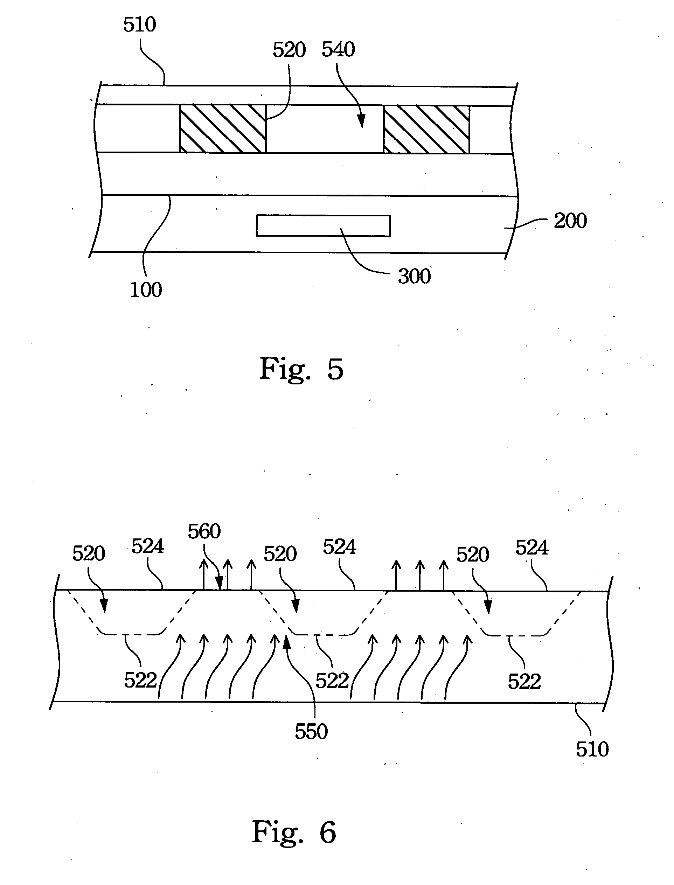

Fig. 5 is a partial side view of the frame of the photovoltaic module shown in Fig. 3. Fig. 6 is a partial top view of the frame of the photovoltaic module shown in Fig. 3. Referring Figs. 3, 5 and 6, the second wind tunnel structure 500 includes a plurality of inlets 550 and a plurality of outlets 560 so as to guide airflow towards an upper surface of the photovoltaic panel 600, thereby dissipating the heat energy accumulating above the photovoltaic panel 600.

For example, the second wind tunnel structure 500 may comprise a flow guiding sheet 510 and a plurality of supports 520 supporting the flow guiding sheet 510. The flow guiding sheet 510 and the supports 520 may define a plurality of inlets 550 and a plurality of outlets 560 (see Fig. 6). Specifically, as shown in Fig. 5, the flow guiding sheet 510 is supported by numerous supports 520, and these supports 520 are disposed on the holding part 100 and spatially separated from each other. Adjacent supports 520 define a cavity 540 therebetween. The entrance of the cavity 540 for the intake of airflow defines the inlet 550 (see Fig. 6), and the vent of the cavity 540 for exhausting airflow defines the outlet 560 (see Fig. 6).

In some embodiments, the cross-sectional area of the inlet 550 of the second wind tunnel structure 500 is greater than the cross-sectional area of the outlet 560 of the second wind tunnel structure 500. As shown in Fig. 6, each of the supports 520 includes a windward surface 522 and a leeward surface 524. The cross-sectional area of the windward surface 522 is less than the cross-sectional area of the leeward surface 524. Because each of the inlets 550 is formed between the windward surfaces 522 of pair of adjacent supports 520, and the outlet 560 is formed between the leeward surfaces 524 of a pair of adjacent supports 520, the cross-sectional area of the inlet 550 can be greater than the cross-sectional area of the outlet 560. Therefore, the velocity of the airflow passing through the outlet 560 is greater than the velocity of the airflow passing through the inlet 550, so that the second wind tunnel structure 500 can further accelerate airflow and improve heat dissipating ability.

Referring back to Fig. 3, in some embodiments, the photovoltaic panel 600 comprises at least one solar cell 620. An angle 530 is defined by the second wind tunnel structure 500 and the solar cell 620. Specifically, an imaginary connecting line is drawn between an edge of the upper surface of one of the supports 520 closest to the solar cell 620 and an edge of the upper surface of the solar cell 620 nearest to the support 520, and the angle 530 is defined between the upper surface of the photovoltaic panel 600 and the connecting line. The angle 530 is less than a particular angle to prevent the shadow of the support 520 from being projected onto the solar cell 620 and affecting the power generating efficiency. In one embodiment, the angle is less than 66.5 degrees.

In some embodiments, the flow guiding sheet 510 can include a reflective surface 570 facing the photovoltaic panel 600. The reflective surface 570 is substantially arc-shaped for concentrating light. In this case, light emitted onto the reflective surface 570 can be reflected to the photovoltaic panel 600, thereby increasing the amount of solar energy that the photovoltaic panel 600 receives.

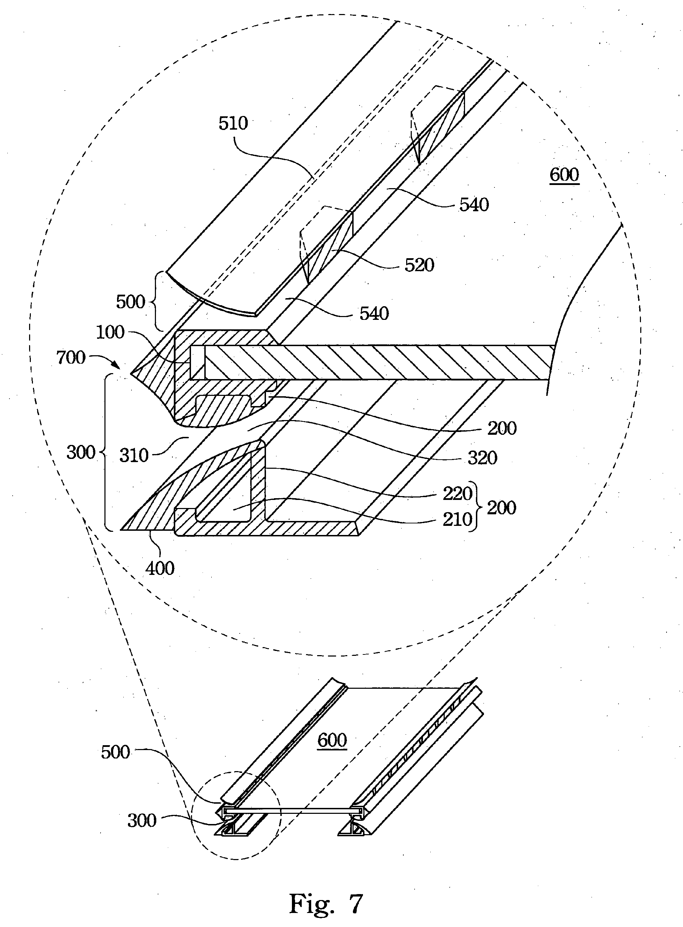

Fig. 7 is a perspective view of the photovoltaic module in accordance with one embodiment shown in Fig. 3 and a partial cross-sectional view of a frame thereof. As shown in this figure, the photovoltaic module includes a photovoltaic panel 600 and a frame 700. The frame 700 holds at least one side of the photovoltaic panel 600. The frame 700 is similar to the frame described in the aforementioned embodiments, and it includes a holding part 100 and an extending part 200. The holding part 100 comprising a concave is configured to hold the photovoltaic panel 600. The extending part 200 is connected to the holding part 100, and it includes at least one first wind tunnel structure 300. The cross-sectional area of the inlet 310 of the first wind tunnel structure 300 is greater than the cross-sectional area of the outlet 320 of the first wind tunnel structure 300. Further, referring to Figs. 3, 5, and 7, the upper extending part 202 is connected to the lower extending part 204. Specifically, referring to Fig. 5, at least one first wind tunnel structure 300 is formed on the extending part 200, and the structure on a portion of the extending part 200 where the first wind tunnel structure 300 is not disposed is not cut away. In other words, the upper extending part 202 and the lower extending part 204 are connected on a portion of the extending part 200 where the first wind tunnel structure 300 is not located. In this case, the number of the first wind tunnel structures 300 can be determined by the strength of the frame 700 and the heat dissipation requirements.

Embodiments of the present invention can accelerate airflow by using the difference between the cross-sectional area of the inlet 310 of the first wind tunnel structure 300 and the cross-sectional area of the outlet 320 of the first wind tunnel structure 300, so that the airflow can flow over the photovoltaic panel 600 in higher speed, thereby improving the heat dissipation ability.

## Claims

1. A frame (700) of a photovoltaic module for holding a photovoltaic panel (600), **characterized by** comprising:
a holding part (100) for holding the photovoltaic panel (600);
an extending part (200) connected to the holding part (100), the extending part (200) comprising at least one first wind tunnel structure (300), wherein a cross-sectional area of an inlet (310) of the first wind tunnel structure (300) is greater than a cross-sectional area of an outlet (320) of the first wind tunnel structure (300); and **characterised by**
a second wind tunnel structure (500) disposed on the holding part (100), the second wind tunnel structure (500) having a plurality of inlets (550) and a plurality of outlets (560), wherein a cross-sectional area of the inlets (550) of the second wind tunnel structure (500) is greater than a cross-sectional area of the outlets (560) of the second wind tunnel structure (500)..

2. The frame (700) of a photovoltaic module according to claim 1, **characterized in that** the inlet (310) of the first wind tunnel structure (300) is an intake (212) formed in an outer wall (210) of the extending part (200), the outlet (320) of the first wind tunnel structure (300) is a vent (222) formed in an inner wall (220) of the extending part (200), and a cross-sectional area of the intake (212) is greater than a cross-sectional area of the vent (222).

3. The frame (700) of a photovoltaic module according to claim 1, **characterized in that** the first wind tunnel structure (300) comprises:
an intake (212) formed in an outer wall (210) of the extending part (200);
a vent (222) formed in an inner wall (220) of the extending part (200); and
at least one flow guiding structure (400) connected to the intake (212) and the vent (222), the flow guiding structure (400) having a windward opening (410), wherein a cross-sectional area of the windward opening (410) of the flow guiding structure (400) is greater than a cross-sectional area of the intake (212) formed in the outer wall (210).

4. The frame (700) of a photovoltaic module according to claim 3, **characterized in that** the cross-sectional area of the intake (212) formed in the outer wall (210) is greater than a cross-sectional area of the vent (222) formed in the inner wall (220).

5. The frame (700) of a photovoltaic module according to claim 4, **characterized in that** part of the flow guiding structure (400) is extended out of the outer wall of the extending part (200).

6. The frame (700) of a photovoltaic module according to claim 1, **characterized in that** the second wind tunnel structure (500) comprises a flow guiding sheet (510) and a plurality of supports (520), and the flow guiding sheet (510) and the supports (520) define the inlets (550) of the second wind tunnel structure (500) and the outlets (560) of the second wind tunnel structure (500).

7. The frame (700) of a photovoltaic module according to claim 6, **characterized In that** the flow guiding sheet (510) comprises a reflective surface (570) facing the photovoltaic panel (600).

8. A photovoltaic module comprising:
a photovoltaic panel (600);
a frame (700) comprising:
a holding part (100) holding the photovoltaic panel (600);
an extending part (200) connected to the holding part (100), the extending part (200) comprising at least one first wind tunnel structure (300), wherein a cross-sectional area of an inlet (310) of the first wind tunnel structure (300) is greater than a cross-sectional area of an outlet (320) of the first wind tunnel structure (300); and **characterised by**
a second wind tunnel structure (500) disposed on the holding part (100), the second wind tunnel structure (500) having a plurality of inlets (550) and a plurality of outlets (560), wherein a cross-sectional area of the inlets (550) of the second wind tunnel structure (500) is greater than a cross-sectional area of the outlets (560) of the second wind tunnel structure (500).

9. The photovoltaic module according to claim 8, wherein the inlet (310) of the first wind tunnel structure (300) is an intake (212) formed in an outer wall (210) of the extending part (200);
wherein the outlet (320) of the first wind tunnel structure (300) Is a vent (222) formed in an inner wall (220) of the extending part (200), and a cross-sectional area of the intake (212) is greater than a cross-sectional area of the vent (222).

10. The photovoltaic module according to claim 8, **characterized in that** the first wind tunnel structure (300) comprises:
an intake (212) formed in an outer wall (210) of the extending part (200);
a vent (222) formed in an inner wall (220) of the extending part (200); and
at least one flow guiding structure (400) connected to the intake (212) and the vent (222), the flow guiding structure (400) having a windward opening (410), wherein a cross-sectional area of the windward opening (410) of the flow guiding structure (400) is greater than a cross-sectional area of the intake (212) formed in the outer wall (210).

11. The photovoltaic module according to claim 10, **characterized in that** the cross-sectional area of the intake (212) formed in the outer wall (210) is greater than a cross-sectional area of the vent (222) formed in the inner wall (220).

12. The photovoltaic module according to claim 8, **characterized in that** the second wind tunnel structure (500) comprises a flow guiding sheet (510) and a plurality of supports (520), and the flow guiding sheet (510) and the supports (520) define the inlets (550) of the second wind tunnel structure (500) and the outlets (560) of the second wind tunnel structure (500).

13. The photovoltaic module according to claim 12, **characterized in that** the flow guiding sheet (510) comprises a reflective surface (570) facing the photovoltaic panel (600).

## Patentansprüche

1. Rahmen (700) eines Photovoltaikmoduls zum Halten eines Photovoltaikelements (600), **dadurch gekennzeichnet, dass** er umfasst:
ein Halteteil (100) zum Halten des Photovoltaikelements (600);
ein Ausdehnungsteil (200), das mit dem Halteteil (100) verbunden ist, wobei das Ausdehnungsteil (200) mindestens eine erste Windtunnelstruktur (300) aufweist, wobei eine Querschnittsfläche eines Einlasses (310) der ersten Windtunnelstruktur (300) größer ist als eine Querschnittsfläche eines Auslasses (320) der ersten Windtunnelstruktur (300),
**gekennzeichnet durch**
eine zweite Windtunnelstruktur (500), die an dem Halteteil (100) angeordnet ist, wobei die zweite Windtunnelstruktur (500) eine Vielzahl von Einlässen (550) und eine Vielzahl von Auslässen (560) aufweist, wobei eine Querschnittsfläche der Einlässe (550) der zweiten Windtunnelstruktur (500) größer ist als eine Querschnittsfläche der Auslässe (560) der zweiten Windtunnelstruktur (500).

2. Rahmen (700) eines Photovoltaikmoduls nach Anspruch 1,
**dadurch gekennzeichnet, dass**
der Einlass (310) der ersten Windtunnelstruktur (300) eine Einlassöffnung (212) ist, die in einer Außenwand (210) des Ausdehnungsteils (200) ausgebildet ist, wobei der Auslass (320) der ersten Windtunnelstruktur (300) eine Entlüftungsöffnung (222) ist, die in einer Innenwand (220) des Ausdehnungsteils (200) ausgebildet ist, und wobei eine Querschnittsfläche der Einlassöffnung (212) größer ist als eine Querschnittsfläche der Entlüftungsöffnung (222).

3. Rahmen (700) eines Photovoltaikmoduls nach Anspruch 1,
**dadurch gekennzeichnet, dass**
die erste Windtunnelstruktur (300) umfasst:
eine Einlassöffnung (212), die in einer Außenwand (210) des Ausdehnungsteils (200) ausgebildet ist,
eine Entlüftungsöffnung (222), die in einer Innenwand (220) des Ausdehnungsteils (200) ausgebildet ist, und
mindestens eine Flussführungsstruktur (400), die mit der Einlassöffnung (212) und der Entlüftungsöffnung (222) verbunden ist, wobei die Flussführungsstruktur (400) eine Windseitenöffnung (410) aufweist, wobei die Querschnittsfläche der Windseitenöffnung (410) der Flussführungsstruktur (400) größer ist als die Querschnittsfläche der in der Außenwand (210) ausgebildeten Einlassöffnung (212).

4. Rahmen (700) eines Photovoltaikmoduls nach Anspruch 3,
**dadurch gekennzeichnet, dass**
die Querschnittsfläche der in der Außenwand (210) ausgebildeten Einlassöffnung (212) größer ist als eine Querschnittsfläche der in der Innenwand (220) ausgebildeten Entlüftungsöffnung (222).

5. Rahmen (700) eines Photovoltaikmoduls nach Anspruch 4,
**dadurch gekennzeichnet, dass**
ein Teil der Flussführungsstruktur (400) sich von der Außenwand des Ausdehnungsteils (200) nach außen erstreckt.

6. Rahmen (700) eines Photovoltaikmoduls nach Anspruch 1,
**dadurch gekennzeichnet, dass**
die zweite Windtunnelstruktur (500) eine Flussführungsplatte (510) und eine Vielzahl von Lager (520) umfasst, und wobei die Flussführungsplatte (510) und die Lager (520) die Einlässe (550) der zweiten Windtunnelstruktur (500) und die Auslässe (560) der zweiten Windtunnelstruktur (500) definieren.

7. Rahmen (700) eines Photovoltaikmoduls nach Anspruch 6,
**dadurch gekennzeichnet, dass**
die Flussführungsplatte (510) eine dem Photovoltaikelement (600) zugewandte, reflektierende Oberfläche (570) aufweist.

8. Photovoltaikmodul umfassend:
ein Photovoltaikelement (600),
einen Rahmen (700) umfassend:
ein Halteteil (100) zum Halten des Photovoltaikelements (600),
ein Ausdehnungsteil (200), das mit dem Halteteil (100) verbunden ist, wobei das Ausdehnungsteil (200) mindestens eine erste Windtunnelstruktur (300) aufweist, wobei eine Querschnittsfläche eines Einlasses (310) der ersten Windtunnelstruktur (300) größer als eine Querschnittsfläche eines Auslasses (320) der ersten Windtunnelstruktur (300) ist,
**dadurch gekennzeichnet, dass**
eine zweite Windtunnelstruktur (500) an dem Halteteil (100) angeordnet ist, wobei die zweite Windtunnelstruktur (500) eine Vielzahl von Einlässen (550) und eine Vielzahl von Auslässen (560) aufweist, wobei eine Querschnittsfläche der Einlässe (550) der zweiten Windtunnelstruktur (500) größer ist als eine Querschnittsfläche der Auslässe (560) der zweiten Windtunnelstruktur (500).

9. Photovoltaikmodul nach Anspruch 8, wobei der Einlass (310) der ersten Windtunnelstruktur (300) eine Einlassöffnung (212) ist, die in einer Außenwand (210) des Ausdehnungsteils (200) ausgebildet ist,
wobei der Auslass (320) der ersten Windtunnelstruktur (300) eine Entlüftungsöffnung (222) ist, die in einer Innenwand (220) des Ausdehnungsteils (200) ausgebildet ist, und wobei eine Querschnittsfläche der Einlassöffnung (212) größer ist als eine Querschnittsfläche der Entlüftungsöffnung (222).

10. Photovoltaikmodul nach Anspruch 8,
**dadurch gekennzeichnet, dass**
die erste Windtunnelstruktur (300) umfasst:
eine Einlassöffnung (212), die in einer Außenwand (210) des Ausdehnungsteils (200) ausgebildet ist,
eine Entlüftungsöffnung (222) ist, die an einer Innenwand (220) des Ausdehnungsteils (200) ausgebildet ist, und
mindestens eine Flussführungsstruktur (400), die mit der Einlassöffnung (212) und der Entlüftungsöffnung (222) verbunden ist, wobei die Flussführungsstruktur (400) eine Windseitenöffnung (410) aufweist, wobei die Querschnittsfläche der Windseitenöffnung (410) der Flussführungsstruktur (400) größer ist als die Querschnittsfläche der in der Außenwand (210) ausgebildeten Einlassöffnung (212).

11. Photovoltaikmodul nach Anspruch 10,
**dadurch gekennzeichnet, dass**
die Querschnittsfläche der in der Außenwand (210) ausgebildeten Einlassöffnung (212) größer ist als eine Querschnittsfläche der in der Innenwand (220) ausgebildeten Entlüftungsöffnung (222).

12. Photovoltaikmodul nach Anspruch 8,
**dadurch gekennzeichnet, dass**
die zweite Windtunnelstruktur (500) eine Flussführungsplatte (510) und eine Vielzahl von Lager (520) umfasst, wobei die Flussführungsplatte (510) und die Lager (520) die Einlässe (550) der zweiten Windtunnelstruktur (500) und die Auslässe (560) der zweiten Windtunnelstruktur (500) definieren.

13. Photovoltaikmodul nach Anspruch 12,
**dadurch gekennzeichnet, dass**
die Flussführungsplatte (510) eine dem Photovoltaikelement (600) zugewandte, reflektierende Oberfläche (570) aufweist.

## Revendications

1. Cadre (700) de module photovoltaïque pour maintenir un panneau photovoltaïque (600), **caractérisé par** le fait de comprendre :
une partie de maintien (100) pour maintenir le panneau photovoltaïque (600) ;
une partie d'extension (200) reliée à la partie de maintien (100), la partie d'extension (200) comprenant au moins une première structure de tunnel aérodynamique (300), une zone en coupe transversale d'une entrée (310) de la première structure de tunnel aérodynamique (300) étant plus grande qu'une zone en coupe transversale d'une sortie (320) de la première structure de tunnel aérodynamique (300) et **caractérisé par**
une seconde structure de tunnel aérodynamique (500) disposée sur la partie de maintien (100), la seconde structure de tunnel aérodynamique (500) ayant une pluralité d'entrées (550) et une pluralité de sorties (560), une zone en coupe transversale des entrées (550) de la seconde structure de tunnel aérodynamique (500) étant plus grande qu'une zone en coupe transversale des sorties (560) de la seconde structure de tunnel aérodynamique (500).

2. Cadre (700) de module photovoltaïque selon la revendication 1, **caractérisé en ce que** l'entrée (310) de la première structure de tunnel aérodynamique (300) est un orifice d'admission (212) formé dans une paroi extérieure (210) de la partie d'extension (200), la sortie (320) de la première structure de tunnel aérodynamique (300) est un orifice d'évacuation (222) formé dans une paroi intérieure (220) de la partie d'extension (200) et une zone en coupe transversale de l'orifice d'admission (212) est plus grande qu'une zone en coupe transversale de l'orifice d'évacuation (222).

3. Cadre (700) de module photovoltaïque selon la revendication 1, **caractérisé en ce que** la première structure de tunnel aérodynamique (300) comprend :
un orifice d'admission (212) formé dans une paroi extérieure (210) de la partie d'extension (200) ;
un orifice d'évacuation (222) formé dans une paroi intérieure (220) de la partie d'extension (200) et
au moins une structure de guidage de l'écoulement (400) reliée à l'orifice d'admission (212) et à l'orifice d'évacuation (222), la structure de guidage de l'écoulement (400) ayant une ouverture côté du vent (410), une zone en coupe transversale de l'ouverture côté du vent (410) de la structure de guidage de l'écoulement (400) étant plus grande qu'une zone en coupe transversale de l'orifice d'admission (212) formé dans la paroi extérieure (210).

4. Cadre (700) de module photovoltaïque selon la revendication 3, **caractérisé en ce que** la zone en coupe transversale de l'orifice d'admission (212) formé dans la paroi extérieure (210) est plus grande qu'une zone en coupe transversale de l'orifice d'évacuation (222) formé dans la paroi intérieure (220).

5. Cadre (700) de module photovoltaïque selon la revendication 4, **caractérisé en ce qu'**une partie de la structure de guidage de l'écoulement (400) s'étend à l'extérieur de la paroi extérieure de la partie d'extension (200).

6. Cadre (700) de module photovoltaïque selon la revendication 1, **caractérisé en ce que** la seconde structure de tunnel aérodynamique (500) comprend une tôle de guidage de l'écoulement (510) et une pluralité de supports (520) et la tôle de guidage de l'écoulement (510) et les supports (520) définissent les entrées (550) de la seconde structure de tunnel aérodynamique (500) et les sorties (560) de la seconde structure de tunnel aérodynamique (500).

7. Cadre (700) de module photovoltaïque selon la revendication 6, **caractérisé en ce que** la tôle de guidage de l'écoulement (510) comprend une surface réfléchissante (570) qui fait face au panneau photovoltaïque (600).

8. Module photovoltaïque comprenant :
un panneau photovoltaïque (600) ;
un cadre (700) comprenant :
une partie de maintien (100) qui maintient le panneau photovoltaïque (600) ;
une partie d'extension (200) reliée à la partie de maintien (100), la partie d'extension (200) comprenant au moins une première structure de tunnel aérodynamique (300), une zone en coupe transversale d'une entrée (310) de la première structure de tunnel aérodynamique (300) étant plus grande qu'une zone en coupe transversale d'une sortie (320) de la première structure de tunnel aérodynamique (300) et **caractérisé par**
une seconde structure de tunnel aérodynamique (500) disposée sur la partie de maintien (100), la seconde structure de tunnel aérodynamique (500) ayant une pluralité d'entrées (550) et une pluralité de sorties (560), une zone en coupe transversale des entrées (550) de la seconde structure de tunnel aérodynamique (500) étant plus grande qu'une zone en coupe transversale des sorties (560) de la seconde structure de tunnel aérodynamique (500).

9. Module photovoltaïque selon la revendication 8, l'entrée (310) de la première structure de tunnel aérodynamique (300) étant un orifice d'admission (212) formé dans une paroi extérieure (210) de la partie d'extension (200), la sortie (320) de la première structure de tunnel aérodynamique (300) étant un orifice d'évacuation (222) formé dans une paroi intérieure (220) de la partie d'extension (200) et une zone en coupe transversale de l'orifice d'admission (212) étant plus grande qu'une zone en coupe transversale de l'orifice d'évacuation (222).

10. Module photovoltaïque selon la revendication 8, **caractérisé en ce que** la première structure de tunnel aérodynamique (300) comprend :
un orifice d'admission (212) formé dans une paroi extérieure (210) de la partie d'extension (200) ;
un orifice d'évacuation (222) formé dans une paroi intérieure (220) de la partie d'extension (200) et
au moins une structure de guidage de l'écoulement (400) reliée à l'orifice d'admission (212) et à l'orifice d'évacuation (222), la structure de guidage de l'écoulement (400) ayant une ouverture côté du vent (410), une zone en coupe transversale de l'ouverture côté du vent (410) de la structure de guidage de l'écoulement (400) étant plus grande qu'une zone en coupe transversale de l'orifice d'admission (212) formé dans la paroi extérieure (210).

11. Module photovoltaïque selon la revendication 10, **caractérisé en ce que** la zone en coupe transversale de l'orifice d'admission (212) formé dans la paroi extérieure (210) est plus grande qu'une zone en coupe transversale de l'orifice d'évacuation (222) formé dans la paroi intérieure (220).

12. Module photovoltaïque selon la revendication 8, **caractérisé en ce que** la seconde structure de tunnel aérodynamique (500) comprend une tôle de guidage de l'écoulement (510) et une pluralité de supports (520) et la tôle de guidage de l'écoulement (510) et les supports (520) définissent les entrées (550) de la seconde structure de tunnel aérodynamique (500) et les sorties (560) de la seconde structure de tunnel aérodynamique (500).

13. Module photovoltaïque selon la revendication 12, **caractérisé en ce que** la tôle de guidage de l'écoulement (510) comprend une surface réfléchissante (570) qui fait face au panneau photovoltaïque (600).
